# EUROPEAN PATENT SPECIFICATION

(11) **EP 4 617 693 B1**
(45) Date of publication and mention of the grant of the patent: **02.12.2026**
(21) Application number: 24854332.4
(22) Date of filing: 23.07.2024
(51) Int. Cl.: G01R 31/392, B60L 3/00, B60L 3/12, G01R 19/00, G01R 19/25, G01R 31/3842

(54) **APPARATUS AND METHOD FOR ACQUIRING BATTERY DEGRADATION INDICATOR INFORMATION, BATTERY PACK, AND ELECTRIC VEHICLE**
VORRICHTUNG UND VERFAHREN ZUR ERFASSUNG VON BATTERIEVERSCHLECHTERUNGSINDIKATORINFORMATIONEN, BATTERIEPACK UND ELEKTROFAHRZEUG
APPAREIL ET PROCÉDÉ D'ACQUISITION D'INFORMATION D'INDICATEUR DE DÉGRADATION DE BATTERIE, BLOC-BATTERIE ET VÉHICULE ÉLECTRIQUE

(30) Priority: 16.08.2023 KR 20230107209; 19.07.2024 KR 20240095689
(43) Date of publication of application: 17.09.2025
(73) Proprietor: LG Energy Solution, Ltd., Seoul 07335 (KR)
(72) Inventor: KIM, Young-Joong, Daejeon 34122 (KR)
(74) Representative: Goddar, Heinz J.
(86) International application number: PCT/KR2024/010621
(87) International publication number: WO 2025/037780

(56) References cited:
- CN-A- 110 927 607
- CN-A- 116 148 699
- KR-A- 20150 020 958
- KR-A- 20170 076 411
- KR-A- 20200 131 629
- KR-A- 20210 141 096
- KR-A- 20220 048 372
- LIANG TONGYI ET AL: "On-board incremental capacity/differential voltage curves acquisition for state of health monitoring of lithium-ion batteries", 2018 IEEE INTERNATIONAL CONFERENCE ON APPLIED SYSTEM INVENTION (ICASI), IEEE, 13 April 2018 (2018-04-13), pages 976 - 979, XP033362823, DOI: 10.1109/ICASI.2018.8394434

## Description

### TECHNICAL FIELD

The present disclosure relates to an apparatus and method for acquiring degradation indicator information of a battery.

The present application claims priority to Korean Patent Application No. 10-2023-0107209 filed on August 16, 2023 and Korean Patent Application No. 10-2024-0095689 filed on July 19, 2024 in the Republic of Korea.

### BACKGROUND

Recently, there has been a rapid increase in the demand for portable electronic products such as laptop computers, video cameras and mobile phones, and with the extensive development of electric vehicles, accumulators for energy storage, robots and satellites, many studies are being made on high performance batteries that can be charged and discharged repeatedly.

Currently, commercially available batteries include nickel-cadmium batteries, nickel-hydrogen batteries, nickel-zinc batteries, lithium batteries and the like, and among them, lithium batteries have little or no memory effect, and thus they are gaining more attention than nickel-based batteries for their advantages that recharging can be done whenever it is convenient, the self-discharge rate is very low and the energy density is high.

In general, because batteries degrade while in use, to accurately estimate State of charge (SOC) and State of health (SOH) of degraded batteries, or perform control to increase the life of degraded batteries, it is necessary to accurately determine the state of the batteries.

The degree of degradation of a battery is estimated by detecting at least two peaks from a differential voltage profile generated based on the actually measured value of voltage and current of the battery, and comparing peak feature information of two peaks. CN116148699A represents a prior art example of estimating a degree of degradation of a battery.

However, as the battery degrades, the differential voltage profile gradually change in shape, so a low sampling rate in the voltage and current measurements may reduce the detection precision for each peak of the differential voltage profile.

As a solution, it is necessary to increase the applied sampling rate, but in this case, high capacity memory is required to record battery data, high power is required for sampling, and high computational load is applied to battery data processing.

### SUMMARY

### Technical Problem

The present disclosure is designed to solve the above-described problem, and therefore the present disclosure is directed to providing an apparatus and method for acquiring information of degradation indicators sufficiently reflecting the actual state of degradation of a battery cell with lower computational load applied to a battery system by variably adjusting the sampling rate used to measure a voltage and a current upon which generation of a differential voltage profile of the battery cell is based, a battery pack including the apparatus and an electric vehicle including the battery pack.

These and other objectives and advantages of the present disclosure may be understood from the following description and will become more fully apparent from the exemplary embodiments of the present disclosure. Also, it will be easily understood that the objectives and advantages of the present disclosure may be realized by the means set forth in the appended claims and a combination thereof.

### Technical Solution

To achieve the above-described objective, an apparatus for acquiring battery degradation indicator information according to an aspect of the present disclosure includes a measuring unit configured to generate a voltage sampled value and a current sampled value of a battery cell; and a control unit configured to set first to n-th ranges of interest and first to n-th sampling rates for a charge/discharge process of a current cycle based on previous degradation indicator information in association with a charge/discharge process of a previous cycle. n is a natural number of 2 or greater. During the charge/discharge process of the current cycle, the control unit is configured to acquire the voltage sampled value and the current sampled value of the battery cell at at least one sampling rate selected from a reference sampling rate and the first to n-th sampling rates. The control unit is configured to determine current degradation indicator information by peak detection in at least one of the first to n-th ranges of interest from a current differential voltage profile of the battery cell generated based on the voltage sampled value and the current sampled value acquired during the charge/discharge process of the current cycle.

During the charge/discharge process of the current cycle, the control unit may be configured to select an i-th sampling rate among the first to n-th sampling rates when a capacity value of the battery cell belongs to an i-th range of interest among the first to n-th ranges of interest. i is a natural number that is equal to or smaller than n. During the charge/discharge process of the current cycle, the control unit may be configured to select the reference sampling rate when the capacity value of the battery cell is outside of the first to n-th ranges of interest.

Each of the first to n-th sampling rates may be higher than the reference sampling rate.

At least two of the first to n-th sampling rates may be equal to each other

The previous degradation indicator information may include peak feature data of at least one of first to n-th peaks of interest already detected from a previous differential voltage profile. The peak feature data may indicate at least one of a capacity value, a differential voltage value or kurtosis.

The control unit may be configured to set a size of an i-th range of interest for the charge/discharge process of the current cycle by applying a predetermined negative correspondence relationship to the kurtosis of an i-th peak of interest included in the previous degradation indicator information. i is a natural number that is equal to or smaller than n.

The control unit may be configured to set an upper limit value of an i-th range of interest for the charge/discharge process of the current cycle to be equal to the capacity value of an i-th peak of interest among the first to n-th peaks of interest included in the previous degradation indicator information. i is a natural number that is equal to or smaller than n.

The control unit may be configured to set an i-th sampling rate for the charge/discharge process of the current cycle by applying a predetermined positive correspondence relationship to the kurtosis of an i-th peak of interest included in the previous degradation indicator information. i is a natural number that is equal to or smaller than n.

A battery pack according to another aspect of the present disclosure includes the apparatus for acquiring battery degradation indicator information.

An electric vehicle according to still another aspect of the present disclosure includes the battery pack.

A method for acquiring battery degradation indicator information according to further another aspect of the present disclosure includes setting first to n-th ranges of interest and first to n-th sampling rates for a charge/discharge process of a current cycle based on previous degradation indicator information in association with a charge/discharge process of a previous cycle; during the charge/discharge process of the current cycle, acquiring a voltage sampled value and a current sampled value of a battery cell at at least one sampling rate selected from a predetermined reference sampling rate and the first to n-th sampling rates; and determining current degradation indicator information by peak detection in at least one of the first to n-th ranges of interest from a current differential voltage profile of the battery cell generated based on the voltage sampled value and the current sampled value acquired during the charge/discharge process of the current cycle. n is a natural number of 2 or greater.

The acquiring of the voltage sampled value and the current sampled value of the battery cell may include, during the charge/discharge process of the current cycle, repeatedly performing the following steps: when a capacity value of the battery cell belongs to an i-th range of interest among the first to n-th ranges of interest, acquiring the voltage sampled value and the current sampled value of the battery cell at an i-th sampling rate among the first to n-th sampling rates; and when the capacity value of the battery cell is outside of the first to n-th ranges of interest, acquiring the voltage sampled value and the current sampled value of the battery cell at the reference sampling rate. i is a natural number that is equal to or smaller than n.

The previous degradation indicator information may include peak feature data of at least one of first to n-th peaks of interest already detected from a previous differential voltage profile. The peak feature data may indicate at least one of a capacity value, a differential voltage value or kurtosis.

An upper limit value of an i-th range of interest for the charge/discharge process of the current cycle may be set to be equal to the capacity value of an i-th peak of interest included in the previous degradation indicator information. i may be a natural number that is equal to or smaller than n.

An i-th sampling rate for the charge/discharge process of the current cycle may be set to have a predetermined positive correspondence relationship to the kurtosis of an i-th peak of interest included in the previous degradation indicator information. i is a natural number that is equal to or smaller than n.

### Advantageous Effects

According to at least one of the embodiments of the present disclosure, when measuring the voltage and current of the battery cell upon which generation of the differential voltage profile is based, by dynamically changing the sampling rate, it may be possible to reduce the computational load and improve the precision of peak detection in the differential voltage profile that is a degradation indicator of the battery cell.

Additionally, according to at least one of the embodiments of the present disclosure, by dividing the entire capacity range into a range of interest that is a capacity range in which each peak is expected to appear and the remaining capacity range, and setting the sampling rate applied to the range of interest to be higher than the sampling rate applied to the remaining capacity range, it may be possible to suppress an excessive increase in computational complexity and data storage space required to acquire the differential voltage profile.

The effects of the present disclosure are not limited to the above-mentioned effects, and these and other effects will be clearly understood by those skilled in the art from the appended claims.

### BRIEF DESCRIPTION OF THE DRAWINGS

The accompanying drawings illustrate exemplary embodiments of the present disclosure and together with the following detailed description, serve to provide a better understanding of the technical aspect of the present disclosure, and thus the present disclosure should not be construed as being limited to the drawings.
FIG. 1 is a diagram exemplarily showing an electric vehicle according to the present disclosure.
FIG. 2 is a graph referenced in comparing two voltage profiles generated by two adjacent charge/discharge processes.
FIG. 3 is a graph referenced in comparing two differential voltage profiles having a one-to-one correspondence with the two voltage profiles shown in FIG. 2.
FIG. 4 is a diagram referenced in describing a procedure for setting a range of interest for a charge/discharge process of a specific cycle.
FIGs. 5a to 5c are diagrams referenced in describing a change in peak detection power with a change in applied sampling rate.
FIG. 6 is a flowchart referenced in illustrating a method for acquiring battery degradation indicator information according to another embodiment of the present disclosure.
FIG. 7 is a flowchart referenced in illustrating the sub-routines of the step S610 in FIG. 6.
FIG. 8 is a flowchart referenced in illustrating the sub-routines of the step S611 in FIG. 6.

### DETAILED DESCRIPTION

Hereinafter, the exemplary embodiments of the present disclosure will be described in detail with reference to the accompanying drawings. Prior to the description, it should be understood that the terms or words used in the specification and the appended claims should not be construed as being limited to general and dictionary meanings, but rather interpreted based on the meanings and concepts corresponding to the technical aspect of the present disclosure on the basis of the principle that the inventor is allowed to define the terms appropriately for the best explanation.

Therefore, the embodiments described herein and the illustrations shown in the drawings are exemplary embodiments of the present disclosure to describe the technical aspect of the present disclosure and are not intended to be limiting, so it should be understood that a variety of other equivalents and modifications could have been made thereto at the time the application was filed.

The terms including the ordinal number such as "first", "second" and the like, are used to distinguish one element from another among various elements, but not intended to limit the elements by the terms.

Unless the context clearly indicates otherwise, the terms "comprise" and "include" when used in this specification, specify the presence of stated elements, but do not preclude the presence or addition of one or more other elements. Additionally, the term "control unit" as used herein refers to a processing unit of at least one function or operation, and may be implemented by hardware and software either alone or in combination.

In addition, throughout the specification, it will be further understood that when an element is referred to as being "connected to" another element, it can be directly connected to the other element or intervening elements may be present.

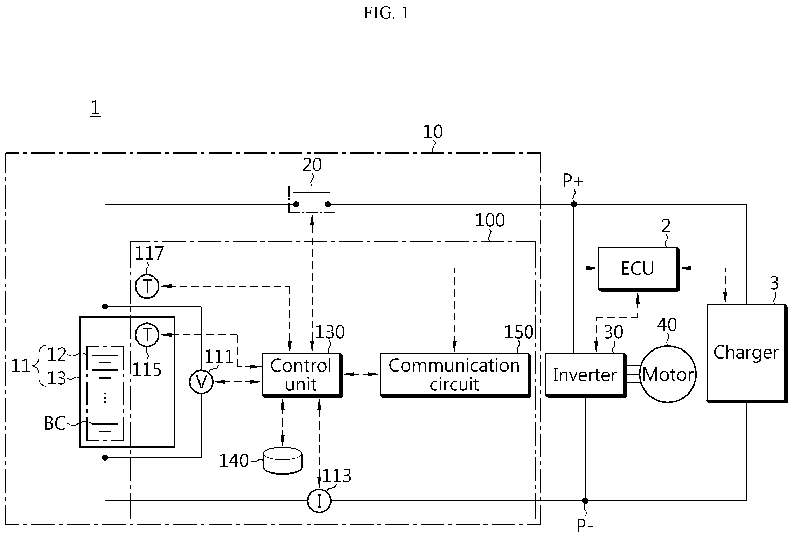

FIG. 1 is a diagram exemplarily showing an electric vehicle according to the present disclosure.

Referring to FIG. 1, the electric vehicle 1 includes a vehicle controller 2, a battery pack 10, a switching device 20, an inverter 30 and an electric motor 40.

Charge/discharge terminals P+, P- of the battery pack 10 may be electrically coupled to the inverter 30 and/or a charger 3 through a charging cable. The charger 3 may be included in the electric vehicle 1, or may be present in a charging station.

The vehicle controller 2 (for example, an Electronic Control Unit (ECU)) is configured to transmit a key-on signal to the battery management system 100 in response to a user's changing a starter button (not shown) of the electric vehicle 1 to an ON-position. The vehicle controller 2 is configured to transmit a key-off signal to the battery management system 100 in response to the user's changing the starter button to an OFF-position. The charger 3 may supply a charge power of a constant current charge mode, a constant voltage charge mode and/or a constant power charge mode to the battery 11 through the charge/discharge terminals P+, P- of the battery pack 10 via communication with the vehicle controller 2.

The battery pack 10 includes a battery 11 and a battery management system 100. The battery management system 100 corresponds to an 'apparatus for acquiring battery degradation indicator information' described in the appended claims.

The battery 11 includes a cell group 12 and a case 13. The case 13 defines the entire external shape of the battery 11, and provides an internal space in which the cell group 12 may be disposed. The case 13 may be fixed and fastened to a battery room of the electric vehicle 1 through bolting.

The cell group 12 is disposed (received) in the internal space of the case 13, and includes at least one battery cell BC. The battery cell BC is not limited to a particular type, and may include any type of battery cell that can be repeatedly charged and discharged such as, for example, a lithium ion cell.

When the cell group 12 includes a plurality of battery cells, the plurality of battery cells may be connected either in series or in parallel or both.

The switching device 20 is electrically connected in series to the battery 11 through a power path connecting the battery 11 and the inverter 30. FIG. 1 shows the switching device 20 connected between a positive terminal of the battery 11 and the charge/discharge terminal P+. The switching device 20 is controlled to turn on/off in response to the switching signal from the battery management system 100. The switching device 20 may be a mechanical contactor that turns on or off by the magnetic force of a coil or a semiconductor switch such as Metal Oxide Semiconductor Field Effect transistor (MOSFET).

The inverter 30 is provided to convert a direct current from the cell group 12 to an alternating current in response to a command from the battery management system 100 or the vehicle controller 2.

The electric motor 40 operates using the alternating current from the inverter 30. The electric motor 40 may include, for example, a 3-phase alternating current motor 40

The battery management system 100 includes a measuring unit, a control unit 130 and a storage unit 140. The battery management system 100 may further include an outdoor temperature sensor 117. The battery management system 100 may further include a communication circuit 150.

The measuring unit includes a voltage sensor 111 and a current sensor 113. The measuring unit may further include a temperature sensor 115. Hereinafter, for convenience of description, the description is made based on the assumption that the measuring unit includes the voltage sensor 111, the current sensor 113 and the temperature sensor 115.

The voltage sensor 111 is connected in parallel to the battery 11 and is configured to detect a battery voltage across the battery 11, and generate a voltage signal indicating the detected battery voltage.

The voltage sensor 111 may be connected to positive and negative terminals of each battery cell BC included in the battery 11, to detect a cell voltage across each battery cell BC, and output an additional voltage signal indicating the cell voltage to the control unit 130.

The current sensor 113 is connected in series to the battery 11 through the current path between the battery 11 and the inverter 30. The current sensor 113 is configured to detect a battery current flowing through the battery 11, and generate a current signal indicating the detected battery current. The current sensor 113 may include one of known current detection devices such as, for example, a shunt resistor or a Hall-effect device or a combination thereof.

The temperature sensor 115 is configured to detect a battery temperature, and generate a temperature signal indicating the detected battery temperature. The temperature sensor 115 may be disposed inside the case 13 to detect the temperature that is close to the actual temperature of the battery 11. For example, the temperature sensor 115 may be attached to the surface of at least one battery cell BC included in the cell group 12, and may detect the temperature on the surface of the battery cell BC as the battery temperature. For reference, the 'temperature detection value' simply described herein may indicate a battery temperature detection value.

The outdoor temperature sensor 117 is configured to detect an outdoor temperature (ambient temperature) at a predetermined location far from the battery 11, and generate a temperature signal indicating the detected outdoor temperature. The outdoor temperature sensor 117 may be disposed at the predetermined location outside of the case 13 where heat exchange between the battery 11 and the outdoor air takes place.

Each of the temperature sensor 115 and the outdoor temperature sensor 117 may include one of known temperature detection devices such as, for example, a thermocouple, a thermistor or a bimetal, or a combination thereof.

The communication circuit 150 is configured to support wired or wireless communication between the control unit 130 and the vehicle controller 2. The wired communication may be, for example, controller area network (CAN) communication, and the wireless communication may be, for example, Zigbee or Bluetooth communication. The communication protocol is not limited to a particular type and may include those that support the wired/wireless communication between the control unit 130 and the vehicle controller 2. The communication circuit 150 may include an output device (for example, a display, a speaker) to provide information received from the control unit 130 and/or the vehicle controller 2 into a recognizable format for the user.

The control unit 130 is operably coupled to at least one of the switching device 20, the voltage sensor 111, the current sensor 113, the temperature sensor 115, the outdoor temperature sensor 117 or the communication circuit 150. The operably coupled refers to direct/indirect connection to enable signal transmission and reception in one or two directions.

The control unit 130 may collect the voltage signal from the voltage sensor 111, the current signal from the current sensor 113, the temperature signal (referred to as 'battery temperature signal') from the temperature sensor 115 and/or the temperature signal (referred to as 'outdoor temperature signal') from the outdoor temperature sensor 117. The control unit 130 may convert each analogue signal collected from the sensors 111, 113, 115, 117 to a digital value by using an Analog to Digital Converter (ADC) equipped therein and record the same.

The control unit 130 may be also referred to as a 'control circuit' or a 'battery controller', and may be implemented in hardware using at least one of application specific integrated circuits (ASICs), digital signal processors (DSPs), digital signal processing devices (DSPDs), programmable logic devices (PLDs), field programmable gate arrays (FPGAs), microprocessors, or electrical units for performing other functions.

The storage unit 140 may include, for example, at least one type of storage medium from flash memory type, hard disk type, Solid State Disk (SSD) type, Silicon Disk Drive (SDD) type, multimedia card micro type, random access memory (RAM), static random access memory (SRAM), read-only memory (ROM), electrically erasable programmable read-only memory (EEPROM) or programmable read-only memory (PROM). The storage unit 140 may store data and programs required for the computation operation by the control unit 130. The storage unit 140 may store data indicating the results of the computation operation by the control unit 130. Although FIG. 1 shows that the storage unit 140 is physically independent from the control unit 130, the storage unit 140 may be included in the control unit 130.

The control unit 130 may turn on the switching device 20 in response to the key-on signal. The control unit 130 may turn off the switching device 20 in response to the key-off signal. The key-off signal is a signal that induces a change from a cycling state to a resting state. Alternatively, instead of the control unit 130, the vehicle controller 2 may take responsibility for the on-off control of the switching device 20.

While the switching device 20 is turned on, when the inverter 30 or the charger 3 operates, the battery 11 is in the cycling state. On the contrary, when the switching device 20 is turned off or the operation of the inverter 30 and the charger 3 is stopped, the battery 11 is in the resting state.

The cycling state refers to a state in which the battery 11 is being charged/discharged, and the resting state refers to a state in which charge/discharge of the battery 11 is stopped. The battery 11 in the cycling or resting state represents that each battery cell BC included in the battery 11 is also in the cycling state or resting state.

For reference, a charge/discharge process as used herein is a procedure according to a protocol for charging and/or discharging the battery cell BC over a predetermined voltage range. The charge/discharge process includes at least one of a charge procedure or a discharge procedure for the battery cell BC, and may further include a resting procedure. As an example, the charge/discharge process may be a procedure for charging the battery cell BC with constant current until the voltage of the battery cell BC reaches the upper voltage limit of the predetermined voltage range from the lower voltage limit. As another example, the charge/discharge process may be a procedure for discharging the battery cell BC with constant current until the voltage of the battery cell BC reaches the lower voltage limit of the predetermined voltage range from the upper voltage limit. The charge/discharge process may include any one of the constant current discharge function or the constant current charge function.

While the charge/discharge process is being performed, the control unit 130 may collect the voltage signal and the current signal indicating the voltage and current of the battery cell BC periodically or aperiodically. The control unit 130 may determine a voltage sampled value and a current sampled value based on the collected voltage signal and current signal, and determine a capacity value of the battery cell BC at every sampling timing during the charge/discharge process by accumulating the current sampled value over time. Accordingly, a voltage time series and a capacity time series reflecting a time-dependent change of each of the voltage sampled value and the capacity value may be updated at the sampling timing of the voltage signal and the current signal.

The control unit 130 may generate a voltage profile indicating a correspondence relationship between the voltage and capacity of the battery cell BC based on the voltage time series and the capacity time series for a period of time from the start time of the charge/discharge process to a specific time during the charge/discharge process or the end time of the charge/discharge process. The control unit 130 may generate a differential voltage profile indicating a correspondence relationship between the capacity and differential voltage of the battery cell BC from the voltage profile of the battery cell BC. The voltage time series, the current time series and the capacity time series may be also referred to as a voltage history, a current history and a capacity history, respectively.

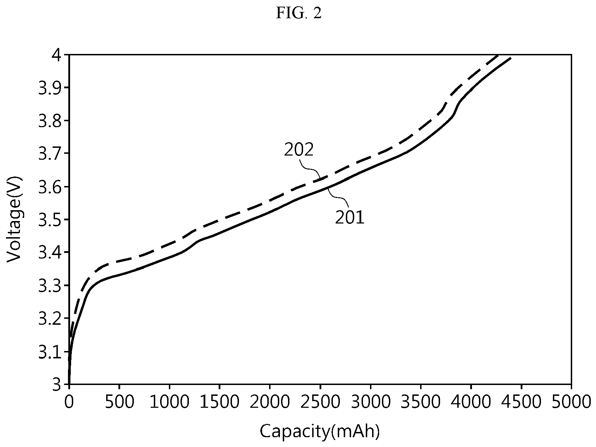

FIG. 2 is a graph referenced in comparing two voltage profiles generated by two adjacent charge/discharge processes. In FIG. 2, X axis (horizontal axis) denotes charge/discharge capacity, and Y axis (vertical axis) denotes voltage. In the present disclosure, the symbol m used as the ordinal number indicates the cycle number of the charge/discharge process of the previous cycle and is a natural number of 1 or greater. As an example, when the charge/discharge process was completed 99 cycles in total from the time when the battery cell BC is new and fresh until now, m is 99. The m-th charge/discharge process may be referred to as the 'charge/discharge process of the previous cycle' or the 'previous charge/discharge process', and the (m+1)-th charge/discharge process may be referred to as the 'charge/discharge process of the current cycle' or the 'current charge/discharge process'. For reference, the voltage profile may be also referred to as a voltage curve, a Q-V profile or a Q-V curve.

The m-th voltage profile 201 indicates the correspondence relationship between the capacity and voltage of the battery cell BC based on the capacity history and the voltage history of the battery cell BC during the m-th charge/discharge process.

Likewise, the (m+1)-th voltage profile 202 indicates the correspondence relationship between the capacity and voltage of the battery cell BC based on the capacity history and the voltage history of the battery cell BC during the (m+1)-th charge/discharge process.

For reference, the capacity history may indicate a time-series change in charge or discharge capacity of the battery cell BC from the start time to the end time of the charge or discharge event. Likewise, the voltage history may indicate a time-series change in voltage of the battery cell BC from the start time to the end time of the charge or discharge event.

Referring to FIG. 2, when comparing the m-th voltage profile 201 with the (m+1)-th voltage profile 202, in the same capacity range, a voltage change of the (m+1)-th voltage profile 202 is larger than a voltage change of the m-th voltage profile 201. This difference may result from the increase in degree of degradation of the battery cell BC caused by capacity loss of the positive electrode and/or negative electrode or lithium plating that may occur in the charge/discharge process of the battery cell BC.

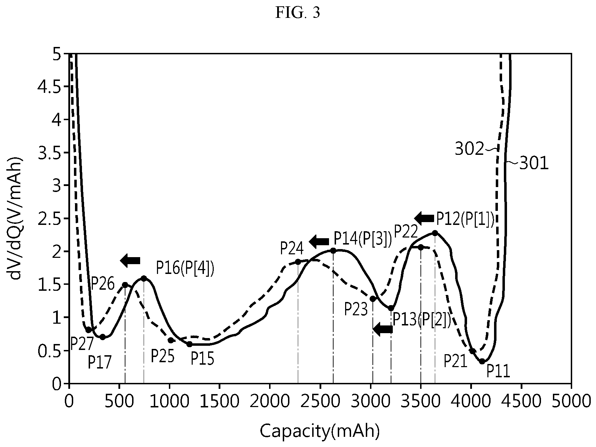

FIG. 3 is a graph referenced in comparing the two differential voltage profiles having a one-to-one correspondence with the two voltage profiles shown in FIG. 2.

In FIG. 3, X axis (horizontal axis) denotes the same charge/discharge capacity as FIG. 2, and Y axis (vertical axis) denotes differential voltage. The differential voltage dV/dQ indicates a ratio of a change dV in voltage to a change dQ in charge or discharge capacity.

Referring to FIGs. 2 and 3, the control unit 130 may acquire an m-th differential voltage profile 301 by differentiating the voltage history of the battery cell BC with respect to its corresponding capacity history, acquired for the m-th charge/discharge process. That is, an m-th voltage profile 201 may be a function of any one of capacity and voltage to the other, and the m-th differential voltage profile 301 may be the result of first order differentiation of the voltage of the m-th voltage profile 201 with respect to the capacity. The m-th differential voltage profile 301 may be also referred to as the 'differential voltage profile of the previous cycle' or the 'previous differential voltage profile'.

Likewise, the control unit 130 may acquire an (m+1)-th differential voltage profile 302 by differentiating the voltage history of the battery cell BC with respect to its corresponding capacity history, acquired for the (m+1)-th charge/discharge process. The (m+1)-th differential voltage profile 302 may be the result of first order differentiation of the voltage of the (m+1)-th voltage profile 202 with respect to the capacity.

Referring to FIG. 3, the (m+1)-th differential voltage profile 302 is a shrunken form of the m-th differential voltage profile 301 to the left along the X axis, and even though the m-th differential voltage profile 301 and the (m+1)-th differential voltage profile 302 have the same voltage range, the capacity history of the m-th differential voltage profile 301 and the capacity history of the (m+1)-th differential voltage profile 302 do not have the same capacity range. The (m+1)-th differential voltage profile 302 may be also referred to as the 'differential voltage profile of the current cycle' or the 'current differential voltage profile'.

For reference, the (m+1)-th charge/discharge process performed to acquire the (m+1)-th differential voltage profile 302 may be performed after the battery cell BC is additionally charged/discharged to some extent from the end of the m-th the charge/discharge process performed to acquire the m-th differential voltage profile 301. Accordingly, the degradation indicator of the battery cell BC reflected on the (m+1)-th differential voltage profile 302 may be severer than the degradation indicator of the battery cell BC reflected on the m-th differential voltage profile 301.

When comparing the two voltage profiles 201, 202 in FIG. 2, a plurality of peaks are located in the two differential voltage profiles 301, 302 shown in FIG. 3. The plurality of peaks may be identified by the order and/or position (the capacity value) for each peak. For example, each of the plurality of peaks may be ranked by the capacity value (in descending or ascending order). In relation, the total number of peaks located in the differential voltage profile in a specific voltage range and/or specific capacity range may be determined by the type of the positive active material and the negative active material of the battery cell BC.

An arbitrary peak in the profile may refer to either the maximum point or the minimum point appearing in the profile or both.

In the present disclosure, peak feature information may include at least one peak parameter indicating the feature of at least one peak appearing in the differential voltage profile.

As an example, the peak feature information of the arbitrary peak includes at least one peak parameter. Here, the capacity and differential voltage as position information (i.e., 2-dimensional coordinates) of the corresponding peak and kurtosis may be included in the peak feature information as an individual peak parameter.

In the present disclosure, the degradation indicator information of the battery cell BC may include the peak feature information of each of first to n-th peaks of interest located in the differential voltage profile. n is a natural number of 2 or greater.

In the present disclosure, the peak of interest may refer to two or more preset peaks among the plurality of peaks located in the differential voltage profile. In relation, each of the plurality of peaks may indicate a specific type of degradation state alone or through comparison with other peak. Accordingly, each peak related to the degradation state to be diagnosed may be programmed to be preset as the peak of interest.

In FIG. 3, the symbols P11 to P17 indicate the plurality of peaks located in the m-th differential voltage profile 301. Additionally, P21 to P27 indicate the plurality of peaks located in the (m+1)-th differential voltage profile 302. When k is a natural number that is equal to or smaller than the total number of peaks, the peak P2k of the (m+1)-th differential voltage profile 302 is a leftward shifted peak of the peak P1k of the m-th differential voltage profile 301. Accordingly, it may be said that the two peaks P1k, P2k are associated with the same type of degradation state.

Additionally, k corresponds to an order in which each of the plurality of peaks of the specific differential voltage profile appears. As an example, when it is assumed that the m-th voltage profile 201 is acquired by constant current discharge, P11 is the peak having the first lowest capacity in the m-th differential voltage profile 301, and P17 is the peak having the last (seventh) highest capacity in the m-th differential voltage profile 301.

Among the plurality of peaks for each differential voltage profile, n peaks located in a specific order may be set as first to n-th peaks of interest of the corresponding differential voltage profile.

In FIG. 3, among the plurality of peaks P11 to P17 appearing in the m-th differential voltage profile 301, four peaks P12, P13, P14, P16 are set as first to fourth peaks of interest P[1] to P[4] in that order. Accordingly, hereinafter, assume n = 4.

When it is assumed that the plurality of peaks P11 to P17 are arranged in a descending order on the basis of the capacity value, the peak of interest P[1] is the second peak (first maximum point), the peak of interest P[2] is the third peak (second minimum point), the peak of interest P[3] is the fourth peak (second maximum point), and the peak of interest P[4] is the sixth peak (third maximum point).

The peaks P22, P23, P24, P26 in the (m+1)-th differential voltage profile 302 correspond to the peaks of interest P[1] to P[4] in the m-th differential voltage profile 301, respectively, and each of the peaks P22, P23, P24, P26 is the peak of interest to be detected from the (m+1)-th differential voltage profile 302.

Hereinafter, assume that i is a natural number that is equal to or smaller than n. The control unit 130 may set the specific capacity range including the capacity value of the i-th peak of interest in the differential voltage profile 301 in association with the m-th charge/discharge cycle as an i-th range of interest in association with the (m+1)-th charge/discharge cycle. That is, each time the charge/discharge process is performed, first to n-th ranges of interest individually in association with the first to n-th peaks of interest may be set. The i-th range of interest is for the detection of the i-th peak of interest.

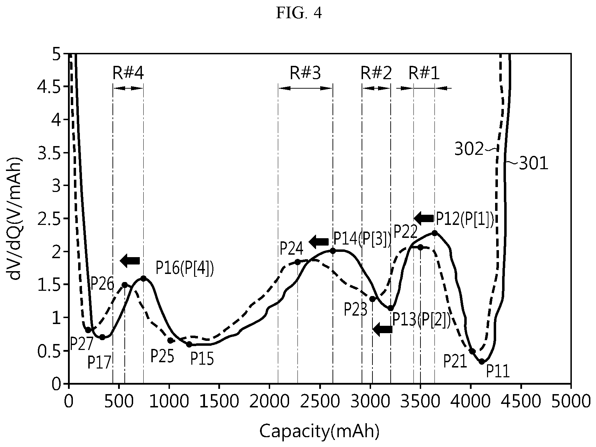

FIG. 4 is a diagram referenced in describing the procedure for setting the range of interest for the charge/discharge process of the specific cycle.

The first to fourth ranges of interest R#1~R#4 shown in FIG. 4 are for the (m+1)-th charge/discharge process.

In setting the range of interest for the (m+1)-th charge/discharge process, the degradation indicator information (also referred to as 'degradation indicator information of the previous cycle', 'previous degradation indicator information' or 'm-th degradation indicator information') of the battery cell BC updated based on the result of the m-th charge/discharge process as already completed may be used.

Referring to FIG. 4, before the (m+1)-th charge/discharge process starts, the control unit 130 may set the first to fourth ranges of interest R#1~R#4 having a one-to-one correspondence with the first to fourth peaks of interest P[1] to P[4] based on the peak feature information of the first to fourth peaks of interest P[1] to P[4] acquired through the m-th charge/discharge process.

The control unit 130 may determine the size and/or the upper/lower limit of the range of interest corresponding to each peak of interest based on the peak feature information of each of the first to n-th peaks of interest P[1] to P[4].

The control unit 130 may set the size of the i range of interest R#i by applying a predetermined negative correspondence relationship to the kurtosis of the i-th peak of interest P[i] acquired in the m-th charge/discharge process. That is, as the kurtosis of the i-th peak of interest P[i] increases, the size of the i-th range of interest R#i may reduce. Here, the kurtosis of the arbitrary peak is a measure of the tailedness of the peak. For example, the kurtosis of the specific peak may be determined to be equal to a difference between the average differential voltage in the predetermined capacity range using the capacity value of the specific peak as a center value and the differential voltage of the specific peak.

As an example, referring to FIG. 4, the size of the fourth range of interest R#4 may be the result of applying the predetermined negative correspondence relationship to the kurtosis of the fourth peak of interest P[4] acquired through the m-th charge/discharge process.

In setting the i-th range of interest R#i, the control unit 130 may set the upper limit value of the i-th range of interest R#i to be equal to the capacity value of the i-th peak of interest P[i] included in the degradation indicator information of the battery cell BC acquired in the m-th charge/discharge process. As an example, the upper limit value of the second range of interest R#2 is equal to the capacity value of the second peak of interest P[2] of the m-th differential voltage profile 301, as can be seen from FIG. 4.

This is because the differential voltage profile tends to shrink to the left (lower capacity) along the X axis as the battery cell BC degrades.

When setting the i-th range of interest R#i for the (m+1)-th charge/discharge process, the control unit 130 may set the capacity value of the i-th peak of interest P[i] acquired in the m-th charge/discharge process as the upper limit value of the i-th range of interest R#i, and set the size of the i-th range of interest R#i in the predetermined negative correspondence relationship with the kurtosis of the i-th peak of interest P[i]. Taking an example with reference to FIG. 4, the control unit 130 may set the upper limit value of the second range of interest R#2 to be equal to the capacity value of the second peak of interest P[2] acquired in the m-th charge/discharge process, and set the size of the second range of interest R#2 to be equal to the result value obtained by applying the predetermined negative relationship to the kurtosis of the second peak of interest P[2].

In the (m+1)-th charge/discharge process, the control unit 130 may determine first to n-th sampling rates to be individually used for the first to n ranges of interest R#1 to R#4 based on the degradation indicator information of the battery cell BC acquired in the m-th charge/discharge process.

The control unit 130 may, at each sampling timing during the (m+1)-th charge/discharge process, select any one of a reference sampling rate and the first to n-th sampling rates, and sample the voltage and current of the battery cell BC at the selected sampling rate. The selected sampling rate may be referred to as 'representative sampling rate'.

The term sampling rate as used herein refers to the number of samples (sampling frequency) per unit time (for example, 1 sec) taken from a continuous signal to make a discrete signal.

In the present disclosure, the reference sampling rate is a sampling rate that is different from the first to n-th sampling rates and may be a basic value of the sampling rate that may be applied at the sampling timing at which the first to n-th sampling rates are not applied. The reference sampling rate may be a preset constant.

Alternatively, the reference sampling rate may be a variable that relies on State Of Health (SOH) of the battery cell BC. The SOH of the battery cell BC may be estimated by a variety of known logics, and its detailed description is omitted.

The relationship data between the SOH and the reference sampling rate may be pre-recorded in the storage unit 140 in the form of a lookup table or a function (for example, a SOH-sampling rate relationship curve). As an example, the relationship data between the SOH and the reference sampling rate defines a negative correspondence relationship in which the reference sampling rate increases as the SOH decreases, and this reflects the characteristic of the battery cell BC that a change in voltage increases as the SOH increases.

In the present disclosure, the representative sampling rate may be used to collect the voltage signal and the current signal indicating the voltage and current of the battery cell BC during the (m+1)-th charge/discharge process.

At each sampling timing during the (m+1)-th charge/discharge process, the control unit 130 may determine whether there is a range of interest to which the capacity value of the battery cell BC (for example, R#1 to R#4 in FIG. 4) belongs among the first to n-th ranges of interest. When the capacity value of the battery cell BC belongs to the i-th range of interest R#i, the control unit 130 may set the i-th sampling rate as the representative sampling rate. In contrast, when the capacity value of the battery cell BC is outside of the first to n-th ranges of interest R#1 to R#4, the control unit 130 may set the reference sampling rate as the representative sampling rate.

The control unit 130 may set at least one of the first to n-th sampling rates to be higher than the reference sampling rate. This is to precisely detect the i-th peak of interest P[i] from a part of the (m+1)-th differential voltage profile 302 corresponding to the i-th range of interest R#i.

The control unit 130 may set at least two of the first to n-th sampling rates to be equal to each other. That is, the sampling rate of the same size may be applied to at least two of the first to n-th ranges of interest R#1 to R#4.

In the (m+1)-th charge/discharge process, the control unit 130 may set the i-th sampling rate by applying a predetermined positive correspondence relationship to the kurtosis of the i-th peak of interest P[i] included in the previous degradation indicator information. As an example, the control unit 130 may determine the fourth sampling rate by multiplying the kurtosis of the fourth peak of interest P[4] by a predetermined positive coefficient.

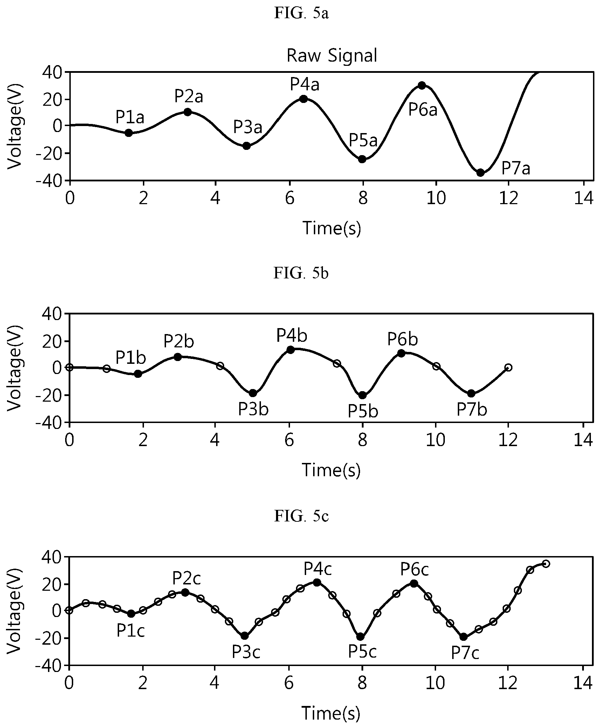

FIGs. 5a to 5c are diagrams referenced in describing a change in peak detection power with a change in the representative sampling rate. In each of FIGs. 5a, 5b and 5c, X axis indicates time, and Y axis indicates amplitude.

Specifically, FIG. 5a is a graph showing a raw signal to be sampled. The raw signal may be, for example, an analogue signal indicating the time-dependent change in voltage, current or differential voltage of the battery cell BC. In FIG. 5a, the symbols P1a to P7a are the actual peaks of the raw signal.

FIG. 5b is a graph showing a plurality of discrete signal values acquired by applying a low sampling rate (1 sample/sec) to the raw signal shown in FIG. 5a. In FIG. 5b, the plurality of peaks indicated by P1b to P7b are peaks in a curve connecting the plurality of discrete signals values.

When comparing FIG. 5a with FIG. 5b, it can be seen that it is difficult to accurately acquire the peak feature information of the raw signal shown in FIG. 5a based on the plurality of discrete signal values shown in FIG. 5b. Specifically, any one of the plurality of peaks P1b to P7b in FIG. 5b does not match the peaks P1a to P7a in FIG. 5a. That is, referring to FIGs. 5a and 5b, when the low sampling rate is applied, it is difficult to acquire the peak feature information of the actual peak of the raw signal sufficiently precisely. In addition, as shown in FIG. 5b, the peak feature information (P1b to P7b in FIG. 5b) of the curve acquired by applying the low sampling rate cannot precisely reflect the degradation indicator information of the battery cell BC.

In contrast, FIG. 5c is a graph showing a plurality of discrete signal values acquired by applying a high sampling rate (2.5 samples/sec) to the raw signal shown in FIG. 5a. In FIG. 5c, the symbols P1c to P7c are peaks in a curve connecting the plurality of discrete signal values acquired at the high sampling rate (2.5 samples/sec).

When comparing FIG. 5a with FIG. 5c, in a one-to-one correspondence between the X axis values corresponding to the plurality of peaks P1a to P7a in FIG. 5a and the X axis values corresponding to the plurality of peaks P1c to P7c in FIG. 5c, a difference in X axis value between the corresponding peaks becomes smaller as the applied sampling rate increases. That is, in FIG. 5c, it was confirmed that the signal values reflecting the peak feature information of the continuous raw signal shown in FIG. 5a more faithfully were acquired by the application of the high sampling frequency per unit time.

Referring to FIGs. 5a, 5b and 5c, it can be seen that it is advantageous to apply the high sampling rate to acquire the discrete signal value(s) including the peak feature information of the raw signal at each sampling timing.

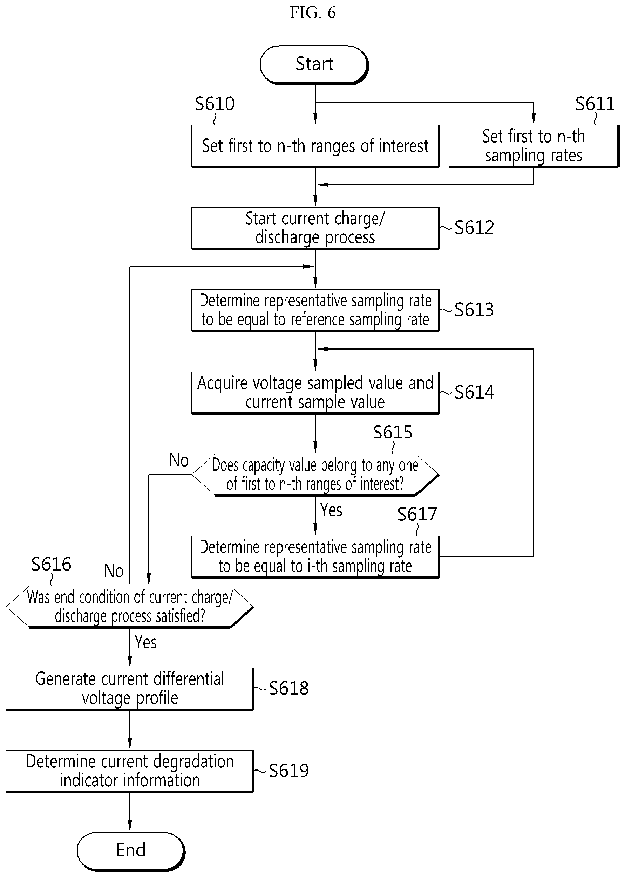

FIG. 6 is a flowchart referenced in illustrating a method for acquiring battery degradation indicator information according to another embodiment of the present disclosure. The method of FIG. 6 may be used to perform a charge/discharge process of a new cycle after the first charge/discharge process for the battery cell BC is completed.

In performing the (m+1)-th charge/discharge process, i.e., the charge/discharge process of the current cycle, the control unit 130 may use the degradation indicator information of the battery cell BC updated in the m-th charge/discharge process, i.e., the charge/discharge process of the previous cycle that has been already completed.

Before the current charge/discharge process is performed, the previous degradation indicator information stored in the storage unit 140 may include the peak feature information of each of the first to n-th peaks of interest P[1]~P[4] located in the differential voltage profile 301 (in FIG. 4) acquired through the m-th charge/discharge process.

Referring to FIGs. 1 to 4 and FIG. 6, in step S610, the control unit 130 may set the first to n-th ranges of interest R#1 to R#4 (in FIG. 4) for the charge/discharge process of the current cycle based on the previous degradation indicator information in association with the charge/discharge process of the previous cycle.

In step S611, the control unit 130 may set the first to n-th sampling rates based on the previous degradation indicator information.

The steps S610 and S611 may be a procedure performed to precisely detect the first to n-th peaks of interest P22, P23, P24, P26 (in FIG. 4) from the differential voltage profile 302 to be acquired through the current charge/discharge process before the start of the current charge/discharge process.

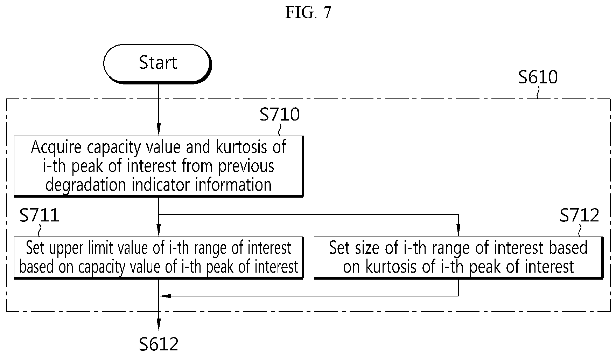

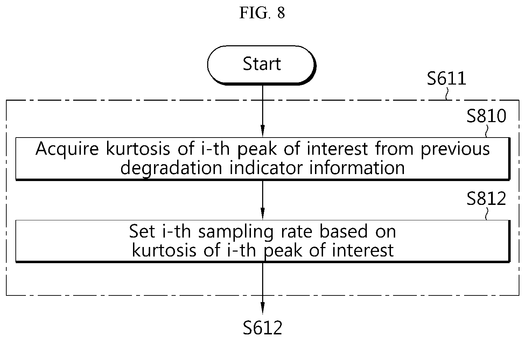

The setting of the i-th range of interest R#i and the i-th sampling rate will be described in detail with reference to FIGs. 7 and 8 below.

In step S612, the control unit 130 may start the current charge/discharge process. For example, the control unit 130 may request the charger 3 to start the charge procedure according to the predetermined charge protocol, or may request the inverter 30 or a discharge circuit (not shown) to start the discharge procedure according to the predetermined discharge protocol. For reference, the capacity value of the battery cell BC when performing the step S612 may be initiated to 0 [Ah].

In step S613, the control unit 130 may determine the representative sampling rate to be equal to the reference sampling rate.

In step S614, the control unit 130 may acquire the voltage sampled value and the current sampled value of the battery cell BC according to the representative sampling rate. Each time the step S614 is performed, the capacity value of the battery cell BC based on the current sampled value may be additionally acquired using a current accumulation method.

In step S615, the control unit 130 may determine whether the capacity value of the battery cell BC belongs any one of the first to n-th ranges of interest R#1 to R#4. That is, in step S615, determination is made as to whether there is a range of interest to which the capacity value of the battery cell BC belongs among the first to n-th ranges of interest R#1 to R#4.

When the capacity value acquired in the step S614 belongs to the i-th range of interest R#i, one of the first to n-th ranges of interest R#1 to R#4, the method of FIG. 6 may move to step S617. In contrast, when the capacity value acquired in the step S614 does not belong to any of the first to n-th ranges of interest R#1 to R#4, the method of FIG. 6 may move to step S616.

In the step S617, the control unit 130 may determine the representative sampling rate to be equal to the i-th sampling rate. After the step S617, the method of FIG. 6 may move to the step S614.

In the step S616, the control unit 130 may determine whether the end condition of the current charge/discharge process is satisfied. As an example, when the current charge/discharge process is a constant current charge procedure, the charge/discharge process end condition may be satisfied when the voltage sampled value acquired in the step S614 is equal to or more than the upper voltage limit (end-of-charge voltage) of the predetermined voltage range. As another example, when the current charge/discharge process is a constant current discharge procedure, the charge/discharge process end condition may be satisfied when the voltage sampled value acquired in the step S614 is equal to or less than the lower voltage limit (end-of-discharge voltage) of the predetermined voltage range.

When the value of the step S616 is "NO", the method of FIG. 6 may revert to the step S613.

The output value "YES" of the step S616 represents that the voltage of the battery cell BC was changed from any one of the upper voltage limit and the lower voltage limit of the predetermined voltage range to the other one by the current charge/discharge process. When the value of the step S616 is 'YES', the method of FIG. 6 may move to step S618.

In the step S618, the control unit 130 may generate the current differential voltage profile 302 (in FIG. 4) for the current charge/discharge process. The current differential voltage profile indicates the correspondence relationship between the capacity and differential voltage of the battery cell BC during the current charge/discharge process.

In step S619, the control unit 130 determines current degradation indicator information by peak detection in at least one of the first to n-th ranges of interest for the current differential voltage profile 302 (in FIG. 4). For example, the previous degradation indicator information may be updated to the current degradation indicator information based on the first to n-th peaks of interest P22, P23, P24, P26 (in FIG. 4) detected from the current differential voltage profile. The current degradation indicator information acquired as a result of the step S619 may include a capacity value, a differential voltage value and/or kurtosis of at least one of the peaks of interest P22, P23, P24, P26 newly detected from the current differential voltage profile 302.

FIG. 7 is a flowchart referenced in illustrating the sub-routines of the step S610 in FIG. 6.

In step S710, the control unit 130 may acquire the capacity value and kurtosis of the i-th peak of interest P[i] from the previous degradation indicator information.

In step S711, the control unit 130 may set the upper limit value of the i-th range of interest R#i based on the capacity value of the i-th peak of interest P[i].

Obviously, degradation of the battery cell BC in the current charge/discharge process is more severe than that of the previous charge/discharge process, and as the battery cell BC degrades, the differential capacity profile tends to shrink to the left along the X axis (horizontal axis) as described above. Accordingly, considering that the capacity value of the peaks of interest P22, P23, P24, P26 that will be detected from the differential voltage profile 302 that will be acquired as a result of the (m+1)-th charge/discharge process is expected to be smaller than the capacity value of the peaks of interest P[1] to P[4] already detected through the previous charge/discharge process, the upper limit value of the i-th range of interest R#i may be set to be equal to the capacity value of the i-th peak of interest P[i] already detected through the previous charge/discharge process. The control unit 130 may variably set the first to n-th ranges of interest (R#1 to R#4 in FIG. 4), and set the capacity value that is larger than the capacity value of the i-th peak of interest P[i] as the upper limit value of the i-th range of interest R#i.

In step S712, the control unit 130 may determine the size of the i-th range of interest R#i based on the kurtosis of the i-th peak of interest P[i]. As an example, the control unit 130 may set the size of the i-th range of interest R#i based on the kurtosis of the i-th peak of interest P[i] using the predetermined negative correspondence relationship.

In the steps S711 and S712, when the size and the upper limit value of the i-th range of interest R#i among the first to n-th ranges of interest R#1 to R#4 are determined, the lower limit value of the i-th range of interest R#i is equal to a value obtained by subtracting the size from the upper limit value.

FIG. 8 is a flowchart referenced in illustrating the sub-routines of the step S611 in FIG. 6.

In step S810, the control unit 130 may acquire the kurtosis of the i-th peak of interest P[i] from the previous degradation indicator information.

In step S812, the control unit 130 may determine the i-th sampling rate based on the kurtosis of the i-th peak of interest P[i]. As an example, the control unit 130 may acquire a reference coefficient (that may be larger than 1) corresponding to the kurtosis of the i-th peak of interest P[i] from the storage unit 140, and determine the i-th sampling rate by multiplying the acquired reference coefficient by the reference sampling rate. The kurtosis of the peak and the reference coefficient may have a positive correspondence relationship, and relationship data defining the correspondence relationship may be prestored in the storage unit 140.

In relation, at least two of the first to n-th sampling rates may be set to be equal to each other. As an example, at least two of the first to n-th sampling rates may be set to be equal to a value that is larger than the reference sampling rate by a predetermined value or a predetermined ratio. As another example, at least two of the first to n-th sampling rates may equal a value obtained by multiplying the reference coefficient corresponding to the kurtosis of any one of the first to fourth peaks of interest P[1]~P[4] by the reference sampling rate.

The embodiments of the present disclosure described hereinabove are not embodied only through the apparatus and method, and may be implemented through programs that perform the functions corresponding to the exemplary configurations of the present disclosure or recording media having the programs recorded thereon, and such implementation may be easily achieved by those skilled in the art from the disclosure of the embodiments previously described.

While the present disclosure has been hereinabove described with regard to a limited number of embodiments and drawings, the present disclosure is not limited thereto and it is obvious to those skilled in the art that various modifications and changes may be made thereto within the technical aspect of the present disclosure and the scope of the appended claims.

## Claims

1. An apparatus for acquiring battery degradation indicator information (100), comprising:
a measuring unit configured to generate a voltage sampled value and a current sampled value of a battery cell (BC); and
a control unit (130) configured to set first to n-th ranges of interest and first to n-th sampling rates for a charge/discharge process of a current cycle based on previous degradation indicator information in association with a charge/discharge process of a previous cycle,
wherein the control unit (130) is configured to:
during the charge/discharge process of the current cycle, acquire the voltage sampled value and the current sampled value of the battery cell (BC) at at least one sampling rate selected from a reference sampling rate and the first to n-th sampling rates, and
determine current degradation indicator information by peak detection in at least one of the first to n-th ranges of interest from a current differential voltage profile of the battery cell generated based on the voltage sampled value and the current sampled value acquired during the charge/discharge process of the current cycle, and
wherein n is a natural number of 2 or greater.

2. The apparatus for acquiring battery degradation indicator information (100) according to claim 1, wherein the control unit (130) is configured to:
during the charge/discharge process of the current cycle,
when a capacity value of the battery cell (BC) belongs to an i-th range of interest among the first to n-th ranges of interest, select an i-th sampling rate among the first to n-th sampling rates, and
when the capacity value of the battery cell (BC) is outside of the first to n-th ranges of interest, select the reference sampling rate, and
wherein i is a natural number that is equal to or smaller than n.

3. The apparatus for acquiring battery degradation indicator information (100) according to claim 1, wherein each of the first to n-th sampling rates is higher than the reference sampling rate.

4. The apparatus for acquiring battery degradation indicator information (100) according to claim 1, wherein at least two of the first to n-th sampling rates are equal to each other.

5. The apparatus for acquiring battery degradation indicator information (100) according to claim 1, wherein the previous degradation indicator information includes peak feature data of at least one of first to n-th peaks of interest already detected from a previous differential voltage profile, and
wherein the peak feature data indicates at least one of a capacity value, a differential voltage value or kurtosis.

6. The apparatus for acquiring battery degradation indicator information (100) according to claim 5, wherein the control unit (130) is configured to set a size of an i-th range of interest for the charge/discharge process of the current cycle by applying a predetermined negative correspondence relationship to the kurtosis of an i-th peak of interest included in the previous degradation indicator information, and
wherein i is a natural number that is equal to or smaller than n.

7. The apparatus for acquiring battery degradation indicator information (100) according to claim 5, wherein the control unit (130) is configured to set an upper limit value of an i-th range of interest for the charge/discharge process of the current cycle to be equal to the capacity value of an i-th peak of interest among the first to n-th peaks of interest included in the previous degradation indicator information, and
wherein i is a natural number that is equal to or smaller than n.

8. The apparatus for acquiring battery degradation indicator information (100) according to claim 5, wherein the control unit (130) is configured to set an i-th sampling rate for the charge/discharge process of the current cycle by applying a predetermined positive correspondence relationship to the kurtosis of an i-th peak of interest included in the previous degradation indicator information, and
wherein i is a natural number that is equal to or smaller than n.

9. A battery pack (10) comprising the apparatus for acquiring battery degradation indicator information (100) according to any one of claims 1 to 8.

10. An electric vehicle (1) comprising the battery pack (10) according to claim 9.

11. A method for acquiring battery degradation indicator information, comprising:
setting first to n-th ranges of interest and first to n-th sampling rates for a charge/discharge process of a current cycle based on previous degradation indicator information in association with a charge/discharge process of a previous cycle;
during the charge/discharge process of the current cycle, acquiring a voltage sampled value and a current sampled value of a battery cell (BC) at at least one sampling rate selected from a predetermined reference sampling rate and the first to n-th sampling rates; and
determining current degradation indicator information by peak detection in at least one of the first to n-th ranges of interest from a current differential voltage profile of the battery cell (BC) generated based on the voltage sampled value and the current sampled value acquired during the charge/discharge process of the current cycle,
wherein n is a natural number of 2 or greater.

12. The method for acquiring battery degradation indicator information according to claim 11, wherein the acquiring of the voltage sampled value and the current sampled value of the battery cell (BC) comprises:
during the charge/discharge process of the current cycle, repeatedly performing the following steps:
when a capacity value of the battery cell (BC) belongs to an i-th range of interest among the first to n-th ranges of interest, acquiring the voltage sampled value and the current sampled value of the battery cell (BC) at an i-th sampling rate among the first to n-th sampling rates; and
when the capacity value of the battery cell (BC) is outside of the first to n-th ranges of interest, acquiring the voltage sampled value and the current sampled value of the battery cell (BC) at the reference sampling rate, and
wherein i is a natural number that is equal to or smaller than n.

13. The method for acquiring battery degradation indicator information according to claim 11, wherein the previous degradation indicator information includes peak feature data of at least one of first to n-th peaks of interest already detected from a previous differential voltage profile, and
wherein the peak feature data indicates at least one of a capacity value, a differential voltage value or kurtosis.

14. The method for acquiring battery degradation indicator information according to claim 13, wherein an upper limit value of an i-th range of interest for the charge/discharge process of the current cycle is set to be equal to the capacity value of an i-th peak of interest included in the previous degradation indicator information, and
wherein i is a natural number that is equal to or smaller than n.

15. The method for acquiring battery degradation indicator information according to claim 13, wherein an i-th sampling rate for the charge/discharge process of the current cycle is set to have a predetermined positive correspondence relationship to the kurtosis of an i-th peak of interest included in the previous degradation indicator information, and
wherein i is a natural number that is equal to or smaller than n.

## Patentansprüche

1. Vorrichtung zum Erfassen von Batterieverschlechterungsindikatorinformationen (100), aufweisend:
eine Messeinheit, die konfiguriert ist, um einen Spannungsabtastwert und einen Stromabtastwert einer Batteriezelle (BC) zu erzeugen; und
eine Steuereinheit (130), die konfiguriert ist, um einen ersten bis einen n-ten relevanten Bereich und eine erste bis eine n-te Abtastrate für einen Lade-/Entladeprozess eines aktuellen Zyklus basierend auf vorherigen Verschlechterungsindikatorinformationen in Verbindung mit einem Lade-/Entladeprozess eines vorherigen Zyklus einzustellen,
wobei die Steuereinheit (130) konfiguriert ist, um:
während des Lade-/Entladeprozesses des aktuellen Zyklus den Spannungsabtastwert und den Stromabtastwert der Batteriezelle (BC) mit mindestens einer Abtastrate zu erfassen, die aus einer Referenzabtastrate und der ersten bis n-ten Abtastrate ausgewählt ist, und
Stromverschlechterungsindikatorinformationen durch Spitzenerkennung in mindestens einem des ersten bis n-ten relevanten Bereichs aus einem Stromdifferenzspannungsprofil der Batteriezelle zu bestimmen, das basierend auf dem Spannungsabtastwert und dem Stromabtastwert erzeugt wird, die während des Lade-/Entladeprozesses des aktuellen Zyklus erfasst werden, und
wobei n eine natürliche Zahl von 2 oder größer ist.

2. Vorrichtung zum Erfassen von Batterieverschlechterungsindikatorinformationen (100) nach Anspruch 1, wobei die Steuereinheit (130) konfiguriert ist, um:
während des Lade-/Entladeprozesses des aktuellen Zyklus,
wenn ein Kapazitätswert der Batteriezelle (BC) zu einem i-ten relevanten Bereich von dem ersten bis n-ten relevanten Bereich gehört, eine i-te Abtastrate von der ersten bis n-ten Abtastrate auszuwählen, und
wenn der Kapazitätswert der Batteriezelle (BC) außerhalb des ersten bis n-ten relevanten Bereichs liegt, die Referenzabtastrate auszuwählen, und
wobei i eine natürliche Zahl ist, die gleich oder kleiner als n ist.

3. Vorrichtung zum Erfassen von Batterieverschlechterungsindikatorinformationen (100) nach Anspruch 1, wobei jede der ersten bis n-ten Abtastrate höher als die Referenzabtastrate ist.

4. Vorrichtung zum Erfassen von Batterieverschlechterungsindikatorinformationen (100) nach Anspruch 1, wobei mindestens zwei der ersten bis n-ten Abtastrate gleich sind.

5. Vorrichtung zum Erfassen von Batterieverschlechterungsindikatorinformationen (100) nach Anspruch 1, wobei die vorherigen Verschlechterungsindikatorinformationen Spitzenwertmerkmalsdaten von mindestens einem des ersten bis n-ten relevanten Spitzwertes enthalten, die bereits aus einem vorherigen Differenzspannungsprofil erkannt sind, und
wobei die Spitzenwertmerkmalsdaten mindestens einen von einem Kapazitätswert, einem Differenzspannungswert oder einer Kurtosis angeben.

6. Vorrichtung zum Erfassen von Batterieverschlechterungsindikatorinformationen (100) nach Anspruch 5, wobei die Steuereinheit (130) konfiguriert ist, um eine Größe eines i-ten relevanten Bereichs für den Lade-/Entladeprozess des aktuellen Zyklus durch Anwenden einer vorbestimmten negativen Entsprechungsbeziehung auf die Kurtosis eines i-ten relevanten Spitzwertes einzustellen, der in den vorherigen Verschlechterungsindikatorinformationen enthalten ist, und
wobei i eine natürliche Zahl ist, die gleich oder kleiner als n ist.

7. Vorrichtung zum Erfassen von Batterieverschlechterungsindikatorinformationen (100) nach Anspruch 5, wobei die Steuereinheit (130) konfiguriert ist, um einen oberen Grenzwert eines i-ten relevanten Bereichs für den Lade-/Entladeprozess des aktuellen Zyklus so einzustellen, dass er gleich dem Kapazitätswert eines i-ten relevanten Spitzwertes von dem ersten bis n-ten relevanten Spitzwert ist, der in den vorherigen Verschlechterungsindikatorinformationen enthalten ist, und
wobei i eine natürliche Zahl ist, die gleich oder kleiner als n ist.

8. Vorrichtung zum Erfassen von Batterieverschlechterungsindikatorinformationen (100) nach Anspruch 5, wobei die Steuereinheit (130) konfiguriert ist, um eine i-te Abtastrate für den Lade-/Entladeprozess des aktuellen Zyklus durch Anwenden einer vorbestimmten positiven Entsprechungsbeziehung auf die Kurtosis eines i-ten relevanten Spitzwertes einzustellen, der in den vorherigen Verschlechterungsindikatorinformationen enthalten ist, und
wobei i eine natürliche Zahl ist, die gleich oder kleiner als n ist.

9. Batteriepack (10), aufweisend die Vorrichtung zum Erfassen von Batterieverschlechterungsindikatorinformationen (100) nach einem der Ansprüche 1 bis 8.

10. Elektrofahrzeug (1), aufweisend den Batteriepack (10) nach Anspruch 9.

11. Verfahren zum Erfassen von Batterieverschlechterungsindikatorinformationen, umfassend:
Einstellen eines ersten bis eines n-ten relevanten Bereichs und einer ersten bis einer n-ten Abtastrate für einen Lade-/Entladeprozess eines aktuellen Zyklus basierend auf vorherigen Verschlechterungsindikatorinformationen in Verbindung mit einem Lade-/Entladeprozess eines vorherigen Zyklus;
während des Lade-/Entladeprozesses des aktuellen Zyklus, Erfassen eines Spannungsabtastwerts und eines Stromabtastwerts einer Batteriezelle (BC) mit mindestens einer Abtastrate, die aus einer vorbestimmten Referenzabtastrate und der ersten bis n-ten Abtastrate ausgewählt ist; und
Bestimmen von Stromverschlechterungsindikatorinformationen durch Spitzenerkennung in mindestens einem des ersten bis n-ten relevanten Bereichs aus einem Stromdifferenzspannungsprofil der Batteriezelle (BC), das basierend auf dem Spannungsabtastwert und dem Stromabtastwert erzeugt wird, die während des Lade-/Entladeprozesses des aktuellen Zyklus erfasst werden,
wobei n eine natürliche Zahl von 2 oder größer ist.

12. Verfahren zum Erfassen von Batterieverschlechterungsindikatorinformationen nach Anspruch 11, wobei das Erfassen des Spannungsabtastwerts und des Stromabtastwerts der Batteriezelle (BC) umfasst:
während des Lade-/Entladeprozesses des aktuellen Zyklus, wiederholtes Durchführen der folgenden Schritte:
wenn ein Kapazitätswert der Batteriezelle (BC) zu einem i-ten relevanten Bereich von dem ersten bis n-ten relevanten Bereich gehört, Erfassen des Spannungsabtastwerts und des Stromabtastwerts der Batteriezelle (BC) mit einer i-ten Abtastrate von der ersten bis n-ten Abtastrate; und
wenn der Kapazitätswert der Batteriezelle (BC) außerhalb des ersten bis n-ten relevanten Bereichs liegt, Erfassen des Spannungsabtastwerts und des Stromabtastwerts der Batteriezelle (BC) mit der Referenzabtastrate, und
wobei i eine natürliche Zahl ist, die gleich oder kleiner als n ist.

13. Verfahren zum Erfassen von Batterieverschlechterungsindikatorinformationen nach Anspruch 11, wobei die vorherigen Verschlechterungsindikatorinformationen Spitzenwertmerkmalsdaten von mindestens einem des ersten bis n-ten relevanten Spitzwertes enthalten, die bereits aus einem vorherigen Differenzspannungsprofil erkannt sind, und
wobei die Spitzenwertmerkmalsdaten mindestens einen von einem Kapazitätswert, einem Differenzspannungswert oder einer Kurtosis angeben.

14. Verfahren zum Erfassen von Batterieverschlechterungsindikatorinformationen nach Anspruch 13, wobei ein oberer Grenzwert eines i-ten relevanten Bereichs für den Lade-/Entladeprozess des aktuellen Zyklus so eingestellt ist, dass er gleich dem Kapazitätswert eines i-ten relevanten Spitzwertes ist, der in den vorherigen Verschlechterungsindikatorinformationen enthalten ist, und
wobei i eine natürliche Zahl ist, die gleich oder kleiner als n ist.

15. Verfahren zum Erfassen von Batterieverschlechterungsindikatorinformationen nach Anspruch 13, wobei eine i-te Abtastrate für den Lade-/Entladeprozess des aktuellen Zyklus so eingestellt ist, dass sie eine vorbestimmte positive Entsprechungsbeziehung zu der Kurtosis eines i-ten relevanten Spitzwertes aufweist, der in den vorherigen Verschlechterungsindikatorinformationen enthalten ist, und
wobei i eine natürliche Zahl ist, die gleich oder kleiner als n ist.

## Revendications

1. Appareil d'acquisition d'informations d'indicateur de dégradation de batterie (100), comprenant :
une unité de mesure configurée pour générer une valeur échantillonnée de tension et une valeur échantillonnée de courant d'une cellule de batterie (BC) ; et
une unité de commande (130) configurée pour définir des première à n-ièmes gammes d'intérêt et des premier à n-ièmes taux d'échantillonnage pour un processus de charge/décharge d'un cycle de courant sur la base d'informations d'indicateur de dégradation antérieures en association avec un processus de charge/décharge d'un cycle antérieur,
dans lequel l'unité de commande (130) est configurée pour :
durant le processus de charge/décharge du cycle de courant, acquérir la valeur échantillonnée de tension et la valeur échantillonnée de courant de la cellule de batterie (BC) à au moins un taux d'échantillonnage sélectionné parmi un taux d'échantillonnage de référence et les premier à n-ièmes taux d'échantillonnage, et
déterminer des informations d'indicateur de dégradation de courant grâce à la détection de crêtes dans au moins une gamme parmi les première à n-ièmes gammes d'intérêt à partir d'un profil de tension différentielle de courant de la cellule de batterie généré sur la base de la valeur échantillonnée de tension et de la valeur échantillonnée de courant acquises durant le processus de charge/décharge du cycle de courant, et
dans lequel n est un nombre naturel de 2 ou davantage.

2. Appareil d'acquisition d'informations d'indicateur de dégradation de batterie (100) selon la revendication 1, dans lequel l'unité de commande (130) est configurée pour :
durant le processus de charge/décharge du cycle de courant,
lorsqu'une valeur de capacité de la cellule de batterie (BC) appartient à une i-ième gamme d'intérêt parmi les première à n-ièmes gammes d'intérêt, sélectionner un i-ième taux d'échantillonnage parmi les premier à n-ièmes taux d'échantillonnage, et
lorsque la valeur de capacité de la cellule de batterie (BC) est en dehors des première à n-ièmes gammes d'intérêt, sélectionner le taux d'échantillonnage de référence, et
dans lequel i est un nombre naturel qui est égal ou inférieur à n.

3. Appareil d'acquisition d'informations d'indicateur de dégradation de batterie (100) selon la revendication 1, dans lequel chaque taux parmi les premier à n-ièmes taux d'échantillonnage est plus élevé que le taux d'échantillonnage de référence.

4. Appareil d'acquisition d'informations d'indicateur de dégradation de batterie (100) selon la revendication 1, dans lequel au moins deux taux parmi les premier à n-ièmes taux d'échantillonnage sont égaux entre eux.

5. Appareil d'acquisition d'informations d'indicateur de dégradation de batterie (100) selon la revendication 1, dans lequel les informations d'indicateur de dégradation antérieures incluent des données de caractéristiques de crête d'au moins une crête parmi les première à n-ièmes crêtes d'intérêt déjà détectées à partir d'un profil de tension différentielle antérieur, et
dans lequel les données de caractéristiques de crête indiquent au moins un élément parmi une valeur de capacité, une valeur de tension différentielle ou un aplatissement.

6. Appareil d'acquisition d'informations d'indicateur de dégradation de batterie (100) selon la revendication 5, dans lequel l'unité de commande (130) est configurée pour définir une taille d'une i-ième gamme d'intérêt pour le processus de charge/décharge du cycle de courant grâce à l'application d'une relation de correspondance négative prédéterminée à l'aplatissement d'une i-ième crête d'intérêt incluse dans les informations d'indicateur de dégradation antérieures, et
dans lequel i est un nombre naturel qui est égal ou inférieur à n.

7. Appareil d'acquisition d'informations d'indicateur de dégradation de batterie (100) selon la revendication 5, dans lequel l'unité de commande (130) est configurée pour définir une valeur limite supérieure d'une i-ième gamme d'intérêt pour le processus de charge/décharge du cycle de courant pour qu'elle soit égale à la valeur de capacité d'une i-ième crête d'intérêt parmi les première à n-ièmes crêtes d'intérêt incluses dans les informations d'indicateur de dégradation antérieures, et
dans lequel i est un nombre naturel qui est égal ou inférieur à n.

8. Appareil d'acquisition d'informations d'indicateur de dégradation de batterie (100) selon la revendication 5, dans lequel l'unité de commande (130) est configurée pour définir un i-ième taux d'échantillonnage pour le processus de charge/décharge du cycle de courant grâce à l'application d'une relation de correspondance positive prédéterminée à l'aplatissement d'une i-ième crête d'intérêt incluse dans les informations d'indicateur de dégradation antérieures, et
dans lequel i est un nombre naturel qui est égal ou inférieur à n.

9. Bloc-batterie (10) comprenant l'appareil d'acquisition d'informations d'indicateur de dégradation de batterie (100) selon n'importe laquelle des revendications 1 à 8.

10. Véhicule électrique (1) comprenant le bloc-batterie (10) selon la revendication 9.

11. Procédé permettant d'acquérir des informations d'indicateur de dégradation de batterie, comprenant :
le fait de définir des première à n-ièmes gammes d'intérêt et des premier à n-ièmes taux d'échantillonnage pour un processus de charge/décharge d'un cycle de courant sur la base d'informations d'indicateur de dégradation antérieures en association avec un processus de charge/décharge d'un cycle antérieur ;
durant le processus de charge/décharge du cycle de courant, le fait d'acquérir une valeur échantillonnée de tension et une valeur échantillonnée de courant d'une cellule de batterie (BC) à au moins un taux d'échantillonnage sélectionné parmi un taux d'échantillonnage de référence prédéterminé et les premier à n-ièmes taux d'échantillonnage ; et
le fait de déterminer des informations d'indicateur de dégradation de courant grâce à la détection de crêtes dans au moins une gamme parmi les première à n-ièmes gammes d'intérêt à partir d'un profil de tension différentielle de courant de la cellule de batterie généré sur la base de la valeur échantillonnée de tension et de la valeur échantillonnée de courant acquises durant le processus de charge/décharge du cycle de courant,
dans lequel n est un nombre naturel de 2 ou davantage.

12. Procédé permettant d'acquérir des informations d'indicateur de dégradation de batterie selon la revendication 11, dans lequel l'acquisition de la valeur échantillonnée de tension et de la valeur échantillonnée de courant de la cellule de batterie (BC) comprend :
durant le processus de charge/décharge du cycle de courant, le fait d'effectuer de manière répétée les étapes suivantes :
lorsqu'une valeur de capacité de la cellule de batterie (BC) appartient à une i-ième gamme d'intérêt parmi les première à n-ièmes gammes d'intérêt, le fait d'acquérir la valeur échantillonnée de tension et la valeur échantillonnée de courant de la cellule de batterie (BC) à un i-ième taux d'échantillonnage parmi les premier à n-ièmes taux d'échantillonnage ; et
lorsque la valeur de capacité de la cellule de batterie (BC) est en dehors des première à n-ièmes gammes d'intérêt, le fait d'acquérir la valeur échantillonnée de tension et la valeur échantillonnée de courant de la cellule de batterie (BC) au taux d'échantillonnage de référence, et
dans lequel i est un nombre naturel qui est égal ou inférieur à n.

13. Procédé permettant d'acquérir des informations d'indicateur de dégradation de batterie selon la revendication 11, dans lequel les informations d'indicateur de dégradation antérieures incluent des données de caractéristiques de crête d'au moins une crête parmi les première à n-ièmes crêtes d'intérêt déjà détectées à partir d'un profil de tension différentielle antérieur, et
dans lequel les données de caractéristiques de crête indiquent au moins un élément parmi une valeur de capacité, une valeur de tension différentielle ou un aplatissement.

14. Procédé permettant d'acquérir des informations d'indicateur de dégradation de batterie selon la revendication 13, dans lequel une valeur limite supérieure d'une i-ième gamme d'intérêt pour le processus de charge/décharge du cycle de courant est définie pour qu'elle soit égale à la valeur de capacité d'une i-ième crête d'intérêt incluse dans les informations d'indicateur de dégradation antérieures, et
dans lequel i est un nombre naturel qui est égal ou inférieur à n.

15. Procédé permettant d'acquérir des informations d'indicateur de dégradation de batterie selon la revendication 13, dans lequel un i-ième taux d'échantillonnage pour le processus de charge/décharge du cycle de courant est défini pour qu'il ait une relation de correspondance positive prédéterminée à l'aplatissement d'une i-ième crête d'intérêt incluse dans les informations d'indicateur de dégradation antérieures, et
dans lequel i est un nombre naturel qui est égal ou inférieur à n.
